# EUROPÄISCHE PATENTSCHRIFT

(11) **EP 1 081 531 B1**
(45) Veröffentlichungstag und Bekanntmachung des Hinweises auf die Patenterteilung: **19.01.2005**
(21) Anmeldenummer: 00114821.2
(22) Anmeldetag: 11.07.2000
(51) Int. Cl.: G02F 1/13

(54) **Flüssigkristall-Anzeige**
Liquid crystal display
Dispositif d'affichage à cristaux liquides

(30) Priorität: 31.08.1999 DE 19941514
(43) Veröffentlichungstag der Anmeldung: 07.03.2001
(73) Patentinhaber: Siemens Aktiengesellschaft, 80333 München (DE)
(72) Erfinder: Simon, Ernst-Ulrich, 61440 Oberursel (DE); Kolibius, Hans, 64832 Babenhausen (DE)

(56) Entgegenhaltungen:
- EP-A- 0 075 213
- EP-A- 0 745 966
- US-A- 4 726 002
- US-A- 5 450 221
- PATENT ABSTRACTS OF JAPAN vol. 1997, no. 07, 31. Juli 1997 (1997-07-31) & JP 09 080431 A (KANSEI CORP), 28. März 1997 (1997-03-28)

## Beschreibung

Die Erfindung betrifft eine Flüssigkristall-Anzeige, insbesondere für ein Kraftfahrzeug, mit einem einen Reflektor aufweisenden Systemträger, einer Flüssigkristallzelle, einem die Flüssigkristallzelle gegen den Reflektor haltenden Frontrahmen und einer Leiterplatte, welche zumindest eine in den Reflektor ragende Lampe aufweist.

Flüssigkristall-Anzeigen der vorstehenden Art sind beispielsweise in heutigen Kraftfahrzeugen als Warneinrichtungen, Bordrechner, Multifunktions- oder Navigationsanzeigen bekannt und gebräuchlich. Da es sich bei ihnen um Massenartikel handelt, besteht das Erfordernis, sie möglichst kostengünstig herzustellen und montieren zu können. Die heutigen Flüssigkristall-Anzeigen bestehen jedoch aus vielen Bauteilen, welche teilweise von der Vorderseite, teilweise von der Rückseite der Flüssigkristall-Anzeige her in ein Gehäuse der Flüssigkristall-Anzeige montiert werden müssen, wobei es erforderlich ist, zum Zwecke der Montage das Gehäuse zu wenden. Die Teilezahl und die erforderliche Art ihres Einbaus machen solche Flüssigkristall-Anzeigen unerwünscht teuer in der Herstellung und Montage.

Flussigkristall-Anzeigen dieser Art sind in US 5 450 221 und EP 0 745 966 ausführlich beschrieben.

Der Erfindung liegt das Problem zugrunde, eine Flüssigkristall-Anzeige der eingangs genannten Art so auszubilden, dass sie möglichst kostengünstig herzustellen und zu montieren ist.

Dieses Problem wird erfindungsgemäß dadurch gelöst, dass der Systemträger an seiner Rückseite einen nach hinten ragenden Ansatz und einen von diesem Ansatz abgewinkelt bis hinter den Reflektor führenden Schacht hat und dass die Leiterplatte abgewinkelt in diesem Schacht und dem Ansatz angeordnet ist.

Durch diese Gestaltung kann man die Leiterplatte von einer Seite des Systemträgers her in den Schacht einschieben und dann durch winkliges Umbiegen des aus dem Schacht herausragenden Bereiches der Leiterplatte in den Ansatz einfügen. Dadurch ist die Montage der Leiterplatte äußerst einfach und deshalb rasch durchzuführen.

Insbesondere bei einer in etwa vertikalen Anordnung der Flüssigkristallzelle in einer Armaturentafel oder einer Mittelkonsole eines Kraftfahrzeugs ist es vorteilhaft raumsparend und vereinfacht den Zusammenbau, wenn gemäß einer vorteilhaften Weiterbildung der Erfindung der Schacht in etwa rechtwinklig von dem Ansatz des Systemträgers abgewinkelt ist und entsprechend die Leiterplatte in etwa rechtwinklig abgewinkelt ist.

Besonders kostengünstig ist die abwinkelbare Leiterplatte gestaltet, wenn sie als Verbundbauteil aus einer flexiblen Schicht und zumindest einer steifen Schicht gebildet ist und wenn die steife Schicht im Bereich der Abwinklung der Leiterplatte entfernt ist.

Der Ansatz mit der Leiterplatte ist vor der Montage des Frontrahmens frei zu erreichen, wenn gemäß einer anderen vorteilhaften Weiterbildung der Erfindung der Ansatz des Systemträgers zu einer Seite hin offen und ausschließlich durch eine Wand des Frontrahmens abgedeckt ist.

Die Montage des Frontrahmens kann gänzlich ohne Verschraubungen oder andere mit einem Werkzeug zu betätigende Befestigungsmittel erfolgen, wenn der Frontrahmen durch Klipsverbindungen mit dem Systemträger verklipst ist.

Besonders sicher und einfach ist der Frontrahmen auf dem Systemträger gehalten, wenn gemäß einer anderen vorteilhaften Weiterbildung der Erfindung der Systemträger an seiner rückwärtigen Seite mehrere Aufnahmen zum Übergreifen von Wandteilen des Frontrahmens hat und die Klipsverbindungen zum Fixieren des Frontrahmens in vollständig auf den Systemträger aufgeschobener Stellung ausgebildet sind.

Die Lampe vermag im eingesetzten Zustand zugleich die Leiterplatte am Gehäuse des Reflektors zu fixieren, wenn sie in eine Durchbrechung der Leiterplatte eingesetzt ist und nach Art einer Bajonettverbindung rückseitig gegen die Leiterplatte und vorderseitig gegen ein fest mit dem Reflektor verbundenes Kunststoffteil anliegt.

Die für die elektrische Kontaktierung der Flüssigkristall-Anzeige z. B. mit einer Flex-Leiterfolie erforderliche Steckeraufnahme kann schon vor der Montage der Leiterplatte auf der Leiterplatte befestigt und mit den erforderlichen elektrischen Verbindungen versehen werden, wenn auf dem in dem Ansatz angeordneten Bereich der abgewinkelten Leiterplatte auf der Leiterplatte eine durch einen Durchbruch des Ansatzes ragende Steckeraufnahme angeordnet ist.

Vorteilhaft ist es auch, wenn der Ansatz an seiner den Durchbruch für die Steckeraufnahme aufweisenden Wand in das Innere des Ansatzes hinein bis gegen die Leiterplatte ragende Distanzvorsprünge aufweist. Solche Distanzvorsprünge vermögen beim Herausziehen eines Steckers aus der Steckeraufnahme die Abzugskräfte aufzunehmen, so dass dabei die Leiterplatte nicht durch solche Kräfte überbeansprucht wird.

Wenn man als Lampe zumindest eine Leuchtdiode (LED) auf der Leiterplatte anordnet, dann kann man vorteilhafterweise vorsehen, dass der Schacht in einer reflektorseitigen Wand für jede Lampe eine über die gesamte Länge des Schachtes verlaufende, zur Seite des Ansatzes hin führende Einführnut aufweist. Hierdurch kann man trotz der vorspringenden Lampe die Leiterplatte mit der auf ihr montierten Lampe von der offenen Seite her in den Schacht einschieben, wobei die Lampe bis zum Erreichen ihrer in den Reflektor ragenden Endposition sich in der Einführnut bewegt.

Besonders gut ist die Flüssigkristall-Anzeige in einem Kraftfahrzeug gehalten und unempfindlich gegen Erschütterungen und Stöße, wenn gemäß einer anderen Weiterbildung der Erfindung der Systemträger an gegenüberliegenden Seiten jeweils eine nach außen hin vorspringende Befestigungslasche hat und der Frontrahmen mit jeweils einer Nut (Freimachung) in jeder Seitenwand über diese Befestigungslaschen greift.

Die Erfindung lässt verschiedene Ausführungsformen zu. Zur weiteren Verdeutlichung ihres Grundprinzips sind eine davon und eine Abwandlung eines Details in der Zeichnung dargestellt und werden nachfolgend beschrieben. Die Zeichnung zeigt in
- Fig. 1: einen Längsschnitt durch eine Flüssigkristall-Anzeige nach der Erfindung,
- Fig. 2: einen Schnitt durch einen Teilbereich eines Schachtes eines Systemträgers der Flüssigkristallanzeige nach Figur 1,
- Fig. 3: einen Verbindungsbereich eines Frontrahmens mit dem Systemträger,
- Fig. 4: einen Schnitt durch den Bereich einer Lampe der Flüssigkristall-Anzeige,
- Fig. 5: eine Prinzipskizze des Systemträgers und Frontrahmens in Explosionsdarstellung.

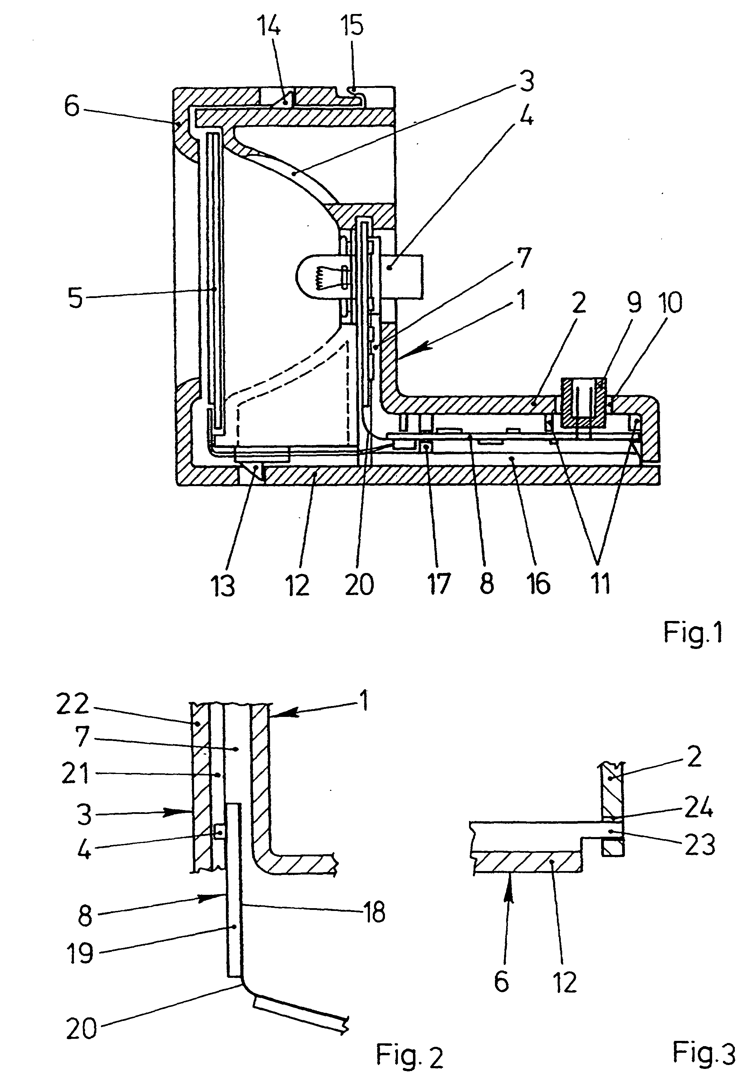

Die Figur 1 zeigt einen Systemträger 1, der zur Rückseite hin einen nach unten hin offenen Ansatz 2 hat. Dieser Systemträger 1 bildet einen zur Vorderseite hin offenen Reflektor 3, in welchen von der Rückseite her eine Lampe 4 ragt. Diese Lampe 4 vermag eine Flüssigkristallzelle 5 zu durchleuchten, welche von vom her durch einen auf den Systemträger 1 aufgeschobenen Frontrahmen 6 gegen den Reflektor 3 gehalten wird.

Der Systemträger 1 hat einen vom Ansatz 2 aus in ihn hineinführenden Schacht 7. In diesem Schacht 7 und in dem Ansatz 2 befindet sich eine durch eine Umbiegung 20 in etwa rechtwinklig abgeknickte Leiterplatte 8, welche einerseits die in den Reflektor 3 ragende Lampe 4, andererseits eine Steckeraufnahme 9 trägt, die durch einen Durchbruch 10 des Ansatzes 2 ragt. Distanzvorsprünge 11 führen in das Innere des Ansatzes 2 hinein bis gegen die Leiterplatte 8, so dass diese beim Abziehen eines nicht gezeigten Steckers aus der Steckeraufnahme 9 sich nicht nach oben hin verlagern kann.

Der Frontrahmen 6 greift mit einer Wand 12 von unten her über den Ansatz 2 und verschließt ihn dazu nach unten. Klipsverbindungen 13, 14 halten den Frontrahmen 6 in der dargestellten Position, in welcher er die Flüssigkristallzelle 5 gegen den Reflektor 3 hält. Weiterhin erkennt man in Figur 1 im rückwärtigen Bereich des Systemträgers 1 eine über den Frontrahmen 6 greifende Aufnahme 15, durch die der Frontrahmen 6 zusätzlich fixiert wird. Die untere Wand 12 des Frontrahmens 6 hat nach oben in den Ansatz 2 ragende Rippen 16 mit Distanzvorsprüngen 17, welche von unten her gegen die Leiterplatte 8 anliegen und diese dadurch fixieren. Außerdem ist die Leiterplatte 8 damit gegen Schwingungsanregung gesichert.

Die Figur 2 verdeutlicht zunächst die Gestaltung der Leiterplatte 8. Diese ist sandwichartig aufgebaut und hat eine flexible Schicht 18 und eine steife Schicht 19, welche im Bereich der Umbiegung 20 entfernt wurde, um das in etwa rechtwinklige Abknicken zu ermöglichen. Bei der in Figur 2 gezeigten Ausführungsform handelt es sich bei der Lampe 4 um eine Leuchtdiode, welche im Vergleich zur in Figur 1 gezeigten Lampe 4 nur relativ geringfügig vorspringt. Deshalb kann man in einer dem Schacht 7 zugewandten Wand 22 des Reflektors 3 eine Einführnut 21 vorsehen, in welche die Lampe 4 beim Einführen der Leiterplatte 8 ragt, so dass eine Montage durch Einschieben von unten möglich wird.

Die Figur 3 zeigt, dass die Wand 12 des Frontrahmens 3 mit einer Zunge 23 in eine Aufnahme 24 des Ansatzes 2 greift und dadurch quer zu seiner Haupterstreckungsrichtung fixiert ist.

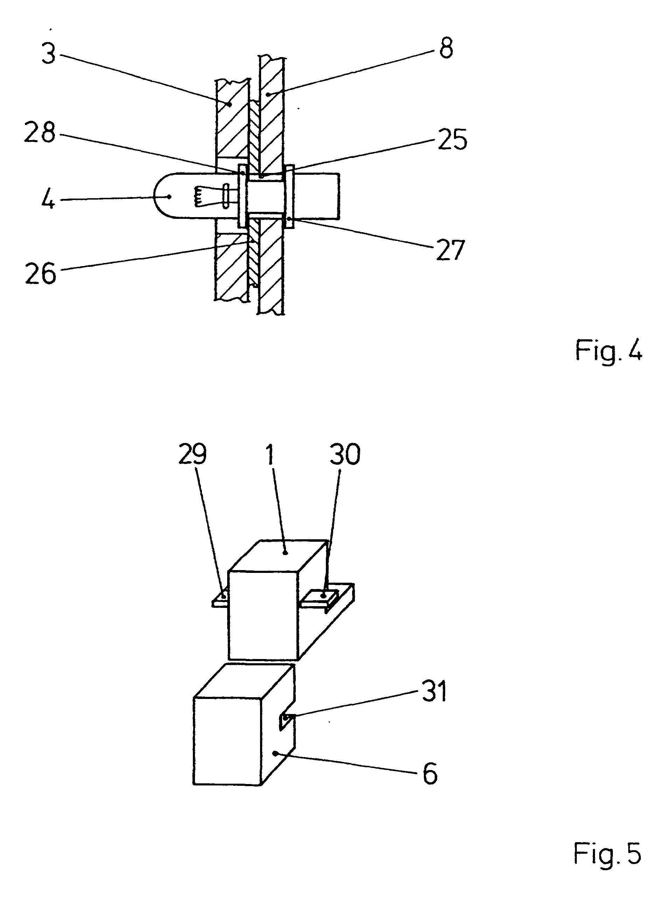

Die Figur 4 zeigt, dass die Leiterplatte 8 zur Montage der Lampe 4 eine Durchbrechung 25 hat, durch die die Lampe 4 gesteckt ist, um in den Reflektor 3 zu ragen. Am Reflektor 3 ist ein Kunststoffteil 26 befestigt. Reflektor 3 und Kunstoffteil 26 können auch ein einziges Bauteil sein. Das Kunstoffteil 26 ist vorgesehen, weil die Lampe 4 zu ihrer sicheren Befestigung eine Mindeststärke der (in sich starren oder flexiblen) Leiterplatte 8 erfordert. Um Kosten durch Reduzieren der Materialstärke der Leiterplatte 8 einsparen zu können, ist die Leiterplatte 8 zur Befestigung der Lampe 4 zu dünn ausgeführt. Im Bereich der Lampe 4 erfolgt eine Verstärkung durch das mit dem Reflektor 3 verbundene Teil 26 auf das notwendige Mindestmaß. Die Lampe 4 greift bajonettartig mit Vorsprüngen 27, 28 über die Rückseite der Leiterplatte 8 und die Vorderseite des Kunststoffteils 26, so dass auf diese Weise die Leiterplatte 8 am Reflektor 3 befestigt wird.

In Figur 5 erkennt man an zwei Seiten des gegenüber den Figuren 1 bis 4 erheblich kleiner und vereinfacht dargestellten Systemträgers 1 jeweils eine nach außen ragende Befestigungslasche 29, 30. Mit diesen Befestigungslaschen 29, 30, die in etwa in Höhe des Schwerpunktes des Systemträgers 1 verlaufen, wird der Systemträger 1 beispielsweise in einer Armaturentafel durch eine Schraubverbindung befestigt. Anschließend schiebt man den Frontrahmen 6 auf den Systemträger 1. Hierzu hat der Frontrahmen 6 an seinen Seiten jeweils eine nach hinten hin offene Nut 31, die beim Aufschieben über die jeweilige Befestigungslasche 29, 30 greift.

Es ist aber auch möglich, das Gerät komplett zusammenzubauen und in diesem Zustand in die Armaturentafel eines Fahrzeugs einzusetzen. Die Freimachung im Frontrahmen dient dann dazu, die Befestigungslaschen des Systemträgers im Geräteschwerpunkt anordnen zu können; andererseits soll der Frontrahmen alle anderen Bereiche des Gerätes zum Schutz vor Umgebungseinflüssen abdecken bzw. verschließen.

## Patentansprüche

1. Flüssigkristall-Anzeige, insbesondere für ein Kraftfahrzeug, welche Flüssigkristallanzeige eine nach vorne weisende Vorderseite und eine nach hinten weisende Rückseite aufweist, mit einem einen Reflektor aufweisenden Systemträger, einer Flüssigkristallzelle (5), einem die Flüssigkristallzelle gegen den Reflektor (3) haltenden Frontrahmen (6) und einer Leiterplatte (8), welche zumindest eine in den Reflektor ragende Lampe (4) aufweist, **dadurch gekennzeichnet, dass** der Systemträger (1) an seiner nach hinten weisenden Rückseite einen nach hinten ragenden Ansatz (2) und einen von diesem Ansatz (2) abgewinkelt bis hinter den Reflektor (3) führenden Schacht (7) hat und dass die Leiterplatte (8) abgewinkelt in diesem Schacht (7) und dem Ansatz (2) angeordnet ist.

2. Flüssigkristall-Anzeige nach Anspruch 1, **dadurch gekennzeichnet, dass** der Schacht (7) in etwa rechtwinklig von dem Ansatz (2) des Systemträgers (1) abgewinkelt ist und dass entsprechend die Leiterplatte (8) in etwa rechtwinklig abgewinkelt ist.

3. Flüssigkristall-Anzeige nach Anspruch 1 oder 2, **dadurch gekennzeichnet, dass** die Leiterplatte (8) als Verbundbauteil aus einer flexiblen Schicht (18) und zumindest einer steifen Schicht (19) gebildet ist und dass die steife Schicht (19) im Bereich der Abwinklung der Leiterplatte (8) entfernt ist.

4. Flüssigkristall-Anzeige nach einem der vorangehenden Ansprüche, **dadurch gekennzeichnet, dass** der Ansatz (2) des Systemträgers (1) zu einer Seite hin offen und ausschließlich durch eine Wand (12) des Frontrahmens (6) abgedeckt ist.

5. Flüssigkristall-Anzeige nach einem der vorangehenden Ansprüche, **dadurch gekennzeichnet, dass** der Frontrahmen (6) durch Klipsverbindungen (13, 14) mit dem Systemträger (1) verklipst ist.

6. Flüssigkristall-Anzeige nach Anspruch 5, **dadurch gekennzeichnet, dass** der Systemträger (1) an seiner rückwärtigen Seite mehrere Aufnahmen (15) zum Übergreifen von Wandteilen des Frontrahmens (6) hat und die Klipsverbindungen (13, 14) zum Fixieren des Frontrahmens (6) in vollständig auf den Systemträger (1) aufgeschobener Stellung ausgebildet sind.

7. Flüssigkristall-Anzeige nach einem der vorangehenden Ansprüche, **dadurch gekennzeichnet, dass** die Lampe (4) in eine Durchbrechung (25) der Leiterplatte (8) eingesetzt ist und nach Art einer Bajonettverbindung rückseitig gegen die Leiterplatte (8) und vorderseitig gegen ein fest mit dem Reflektor (3) verbundenes Kunststoffteil (26).

8. Flüssigkristall-Anzeige nach einem der vorangehenden Ansprüche, **dadurch gekennzeichnet, dass** auf dem in dem Ansatz (2) angeordneten Bereich der abgewinkelten Leiterplatte (8) auf der Leiterplatte (8) eine durch einen Durchbruch (10) des Ansatzes (2) ragende Steckeraufnahme (9) angeordnet ist.

9. Flüssigkristall-Anzeige nach Anspruch 8, **dadurch gekennzeichnet, dass** der Ansatz (2) an seiner den Durchbruch (10) für die Steckeraufnahme (9) aufweisenden Wand in das Innere des Ansatzes (2) hinein bis gegen die Leiterplatte (8) ragende Distanzvorsprünge (11) aufweist.

10. Flüssigkristall-Anzeige nach einem der vorangehenden Ansprüche, bei der als Lampe zumindest eine Leuchtdiode auf der Leiterplatte angeordnet ist, **dadurch gekennzeichnet, dass** der Schacht (7) in einer reflektorseitigen Wand (22) für jede Lampe (4) eine über die gesamte Länge des Schachtes (7) verlaufende, zur Seite des Ansatzes (2) hin führende Einführnut (21) aufweist.

11. Flüssigkristall-Anzeige nach einem der vorangehenden Ansprüche, **dadurch gekennzeichnet, dass** der Systemträger (1) an gegenüberliegenden Seiten jeweils eine nach außen hin vorspringende Befestigungslasche (29, 30) hat und der Frontrahmen (6) mit jeweils einer Nut (31) in jeder Seitenwand über diese Befestigungslaschen (29, 30) greift.

## Claims

1. Liquid crystal display, in particular for a motor vehicle, which liquid crystal display has a front side facing forwards and a rear side facing rearwards, having a system carrier which has a reflector, a liquid crystal cell (5), a front frame (6) which holds the liquid crystal cell against the reflector (3) and a printed circuit board (8) which has at least one incandescent lamp (4) protruding into the reflector, **characterized in that** the system carrier (1) has, on its rear side facing rearwards, a projection (2) which protrudes rearwards and a shaft (7) which leads from this projection (2) in an angled manner to behind the reflector (3), and **in that** the printed circuit board (8) is arranged in an angled manner in this shaft (7) and the projection (2).

2. Liquid crystal display according to Claim 1, **characterized in that** the shaft (7) is angled approximately at right angles from the projection (2) of the system carrier (1), and **in that** the printed circuit board (8) is correspondingly angled approximately at right angles.

3. Liquid crystal display according to Claim 1 or 2, **characterized in that** the printed circuit board (8) is formed as a composite component from a flexible layer (18) and at least one stiff layer (19), and **in that** the stiff layer (19) is removed in the region of the angled section of the printed circuit board (8).

4. Liquid crystal display according to one of the preceding claims, **characterized in that** the projection (2) of the system carrier (1) is open towards one side and is covered exclusively by a wall (12) of the front frame (6).

5. Liquid crystal display according to one of the preceding claims, **characterized in that** the front frame (6) is clipped to the system carrier (1) by clip connections (13, 14).

6. Liquid crystal display according to Claim 5, **characterized in that** the system carrier (1) has, on its rear side, a plurality of retainers (15) for engaging over wall parts of the front frame (6) and the clip connections (13, 14) are designed for fixing the front frame (6) in a position in which it is pushed entirely onto the system carrier (1).

7. Liquid crystal display according to one of the preceding claims, **characterized in that** the incandescent lamp (4) is inserted into an aperture (25) in the printed circuit board (8) and bears in the manner of a bayonet connection on the rear side against the printed circuit board (8) and on the front side against a plastic part (26) which is connected fixedly to the reflector (3).

8. Liquid crystal display according to one of the preceding claims, **characterized in that** on that region of the angled printed circuit board (8) which is arranged in the projection (2) a plug socket (9) which protrudes through an opening (10) in the projection (2) is arranged on the printed circuit board (8).

9. Liquid crystal display according to Claim 8, **characterized in that** the projection (2) has, on its wall which has the opening (10) for the plug socket (9), spacer lugs (11) which protrude into the interior of the projection (2) until they reach the printed circuit board (8).

10. Liquid crystal display according to one of the preceding claims, in which at least one light-emitting diode is arranged on the printed circuit board as the incandescent lamp, **characterized in that**, in a reflector-side wall (22), the shaft (7) has, for each incandescent lamp (4), an introducing groove (21) which runs over the entire length of the shaft (7) and leads towards the side of the projection (2).

11. Liquid crystal display according to one of the preceding claims, **characterized in that** the system carrier (1) has, on opposite sides, a respective outwardly projecting fastening tab (29, 30), and the front frame (6), by means of a respective groove (31) in each side wall, reaches over these fastening tabs (29, 30).

## Revendications

1. Dispositif d'affichage à cristaux liquides destiné, notamment, à un véhicule automobile, ce dispositif d'affichage à cristaux liquides ayant une face avant tournée vers l'avant et une face arrière tournée vers l'arrière, comportant un support de montage supportant un réflecteur, u ne cellule à cristaux liquides (5), un cadre avant (6), qui maintient la cellule à cristaux liquides appliquée contre le réflecteur (3), et une carte à circuits imprimés (8), qui comporte, au moins, une lampe (4) faisant saillie dans le réflecteur, **caractérisé par le fait que** le support de montage (1) a, sur sa face arrière tournée vers l'arrière, un prolongement (2) faisant saillie vers l'arrière et un logement (7), qui part en angle de ce prolongement (2) et conduit jusque derrière le réflecteur (3), et que la carte à circuits imprimés (8) est disposée pliée dans ce logement (7) et dans le prolongement (2).

2. Dispositif d'affichage à cristaux liquides selon la revendication 1 **caractérisé par le fait que** le logement (7) est coudé approximativement en angle droit par rapport au prolongement (2) du support de montage (1 ) et, que d'une façon correspondante, la carte à circuits imprimés (8) est pliée approximativement en angle droit.

3. Dispositif d'affichage à cristaux liquides selon la revendication 1 ou 2 **caractérisé par le fait que** la carte à circuits imprimés (8) est formée, en tant que pièce composée, d'une couche souple (18) et, au moins, d'une couche rigide (19) et que la couche rigide (19) est enlevée dans la zone de cintrage de la carte à circuits imprimés (8).

4. Dispositif d'affichage à cristaux liquides selon l'une des revendications précédentes **caractérisé par le fait que** le prolongement (2) du support de montage (1 ) est ouvert d'un côté et seulement recouvert par une paroi (12) du cadre avant (6).

5. Dispositif d'affichage à cristaux liquides selon l'une des revendications précédentes **caractérisé par le fait que** le cadre avant (6) est agrafé par des liaisons agrafées (13, 14) au support de montage (1).

6. Dispositif d'affichage à cristaux liquides selon la revendication 5 **caractérisé par le fait que** le support de montage (1) a, sur son côté arrière, plusieurs logements (15) qui s'engagent dans les parois du cadre avant (6) et des liaisons à agrafes (13, 14) pour la fixation du cadre avant (6) dans la position complètement enfoncée sur le support de montage (1 ).

7. Dispositif d'affichage à cristaux liquides selon l'une des revendications précédentes **caractérisé par le fait que** la lampe (4) est mise en place dans une ouverture (25) d e la carte à circuits i mprimés (8) et fixée, par u n genre de liaison à baïonnette, par le côté arrière, contre la carte à circuits imprimés (8) et, par le côté avant, contre une pièce en matière plastique (26) fixée définitivement au réflecteur (3).

8. Dispositif d'affichage à cristaux liquides selon l'une des revendications précédentes **caractérisé par le fait que**, sur la partie de la carte à circuits imprimés (8) pliée disposée dans le prolongement (2), est disposée, sur la carte à circuits imprimés (8), une fixation de connecteur (9) faisant saillie à travers une ouverture (10) du prolongement (2).

9. Dispositif d'affichage à cristaux liquides selon la revendication 8 **caractérisé par le fait que** le prolongement (2) comporte, sur sa paroi comportant l'ouverture (10) destinée à la fixation de connecteur (9), des saillies d'écartement (11) dépassant dans l'intérieur du prolongement (2) jusqu'à la carte à circuits imprimés (8).

10. Dispositif d'affichage à cristaux liquides selon l'une des revendications précédentes, dans lequel au moins une diode électroluminescente est disposée sur la carte à circuits imprimés en tant que lampe, **caractérisé par le fait que** le logement (7) comporte, dans une paroi (22) du côté du réflecteur, pour chaque lampe (4), une rainure d'introduction (21) se développant sur toute la longueur du logement (7) et conduisant sur le côté du prolongement (2).

11. Dispositif d'affichage à cristaux liquides selon l'une des revendications précédentes **caractérisé par le fait que** le support de montage (1) a, sur chacun des côtés se faisant face, une patte de fixation (29, 30) faisant saillie vers l'extérieur et que le cadre avant (6) s'engage, avec une rainure (31 ) dans chaque paroi latérale, sur ces pattes de fixation (29, 30).
